# NEUE EUROPÄISCHE PATENTSCHRIFT

(11) **EP 0 120 408 B2**
(45) Veröffentlichungstag und Bekanntmachung des Hinweises auf die Entscheidung über den Einspruch: **21.02.1996**
(45) Hinweis auf die Patenterteilung: 22.07.1987
(21) Anmeldenummer: 84102786.5
(22) Anmeldetag: 14.03.1984
(51) Int. Cl.: C03C 17/36, C23C 14/34

(54) **Verfahren zur Beschichtung eines transparenten Substrates**
Process for coating a transparent substrate
Procédé de revêtement d'un substrat transparent

(30) Priorität: 25.03.1983 DE 3310916; 06.05.1983 DE 3316548
(43) Veröffentlichungstag der Anmeldung: 03.10.1984
(73) Patentinhaber: FLACHGLAS AKTIENGESELLSCHAFT, D-90762 Fürth (DE)
(72) Erfinder: Groth, Rolf, Dr., D-4630 Bochum 6 (DE); Müller, Dieter, D-5900 Siegen 21 (DE)
(74) Vertreter: Andrejewski, Walter, Dr.

(56) Entgegenhaltungen:
- EP-A- 0 035 906
- WO-A-80/00713
- FR-A- 2 318 941
- FR-A- 2 437 634
- US-A- 4 421 622
- Vakuum-Technik, 30. Jahrg., Heft 8, S. 236-246

## Beschreibung

Die Erfindung bezieht sich gattungsgemäß auf ein Verfahren zur Beschichtung eines transparenten Substrates mit einem mehrschichtigen optischen Filter, welches mindestens eine Silberschicht und eine nach außen hin nachgeordnete Entspiegelungsschicht aus Zinnoxid aufweist, wobei die Entspiegelungsschicht mit Hilfe einer reaktiven Magnetron-Kathodenzerstäubung bei vorgegebenem Entspiegelungsschicht-Sauerstoffpartialdruck und vorgegebener Entspiegelungsschicht-Aufstäubrate erzeugt wird. Die Silberschicht kann bzw. die Silberschichten können auf verschiedene Weise aufgebracht werden, vorzugsweise geschieht das in der Praxis mit Hilfe einer Magnetron-Kathodenzerstäubung. Die Entspiegelungsschicht wird vorzugsweise mit Hilfe einer reaktiven Magnetron-Kathodenzerstäubung aufgebracht. Das Verfahren wird zumeist, aber nicht notwendig, im Durchlauf unter Verwendung von Durchlaufschleusenanlagen geführt. Das Substrat kann eine Glasscheibe oder eine Kunststoffplatte sein. Dünne Silberschichten zeichnen sich durch hohe Lichtdurchlässigkeit in Verbindung mit hoher Reflexion für Infrarotstrahlen aus und haben aus diesem Grunde verschiedene Anwendungen gefunden, z. B. um die Wärmedämmung von Fensterscheiben zu verbessern. Diese selektiven Eigenschaften von Silberschichten können noch verbessert werden, wenn auf der dem Substrat abgewandten Seite der Silberschicht eine für das sichtbare Gebiet angepaßte Entspiegelungsschicht aus einem dielektrischen Material mit einem Brechungsindex größer 1.7 angeordnet ist. Weitere Ausführungsformen solcher Filter sehen vor, daß zwischen dem transparenten Substrat und der Silberschicht eine weitere dielektrische Schicht vorgesehen ist, die als Haftvermittler dient und bei Ausbildung als Viertelwellenlängen-Schicht auch zusätzlich noch einen Entspiegelungseffekt bringt. Im Rahmen der gattungsgemäßen Maßnahmen liegt es daher, daß zwischen dem Substrat und der Silberschicht eine oder mehrere weitere Metalloxidschichten angebracht werden.

Auch kann die Entspiegelungsschicht mit einer oder mehreren zusätzlichen Abdeckungsschichten versehen werden. Es liegt ferner im Rahmen der gattungsgemäßen Maßnahmen, zwischen dem transparenten Substrat und der Silberschicht sowie den Metalloxidschichten und der Silberschicht Metallschichten oder Metallegierungsschichten, z. B. aus Chrom, Nickel, Titan, Chrom-Nickel-Legierungen anzuordnen, um die Haftfestigkeit zu verbessern. Dazu reichen bekanntlich sehr dünne Schichten von nur wenigen Atomlagen Dicke (s. DE-OS 21 44 242). Bei der Magnetron-Zerstäubung (US-PS 40 13 532) handelt es sich um ein Vakuumverfahren, welches sich durch hohe Beschichtungsraten auszeichnet. Dieses Verfahren ermöglicht in besonders wirtschaftlicher Weise die Herstellung der im Vergleich zur Silberschicht relativ dicken Entspiegelungsschichten. Dabei wird für die Herstellung der Entspiegelungsschichten, insbesondere wenn es sich um eine Zinnoxidschicht handelt, das Verfahren der reaktiven Magnetron-Zerstäubung angewendet. In einer Gasatmosphäre, die Sauerstoff enthält, werden Metall. bzw. Metalllegierungstargets zerstäubt, wobei sich durch den reaktiven Prozeß auf dem Substrat eine Metalloxid- bzw. eine Metallmischoxidschicht bildet, welche als dielektrische Entspiegelungsschicht funktioniert. Im folgenden wird aus Gründen der terminologischen Vereinfachung mit einigen Abkürzungen gearbeitet, die definiert werden. So steht E-Partialdruck für Entspiegelungsschicht-Sauerstoffpartialdruck und E-Aufstäubrate für Entspiegelungsschicht-Aufstäubrate.

Bei Verwirklichung des (aus der Praxis) bekannten gattungsgemäßen Verfahrens hat sich gezeigt, daß durch das Aufbringen der Entspiegelungsschicht auf die Silberschicht, in einem reaktiven sauerstoffhaltigen Plasma, die Infrarot-Reflexionseigenschaften der Silberschicht verschlechtert werden. So sinkt die Infrarot-Reflexion bei Silberschichten mit einer Infrarot-Reflexion von 90 % vor Aufbringen der Zinnoxidschicht auf Werte zwischen 10 % und 40 % ab. Es ist zwar möglich, den Verlust an Infrarot-Reflexion zumindest teilweise dadurch zu kompensieren, daß die Silberschicht von vornherein etwas dicker aufgebracht wird. Diese Maßnahme führt jedoch zu einem Verlust an Durchlässigkeit im sichtbaren Spektralbereich, was ebenfalls die Wirksamkeit eines solchen Filters verschlechtert. Die Ursachen für diese Veränderungen der Silberschicht durch den Beschichtungsprozeß für die Entspiegelungsschicht sind nicht bekannt.

Der Erfindung liegt die Aufgabe zugrunde, das gattungsgemäße Verfahren so zu führen, daß eine Verschlechterung der Infrarot-Reflexionseigenschaften der Silberschicht nicht mehr eintritt, und zwar selbst dann nicht, wenn für das Aufbringen der Entspiegelungsschicht mit reaktiver Magnetron-Kathodenzerstäubung gearbeitet wird.

Eine Lösung dieser Aufgabe ist dadurch gekennzeichnet, daß auf die Silberschicht vor dem Aufbringen der Entspiegelungsschicht mit Hilfe einer reaktiven Magnetron-Kathodenzerstäubung und metallischen Targets eine metalloxidische Schutzschicht mit einem niedrigen, gegenüber dem E-Partialdruck reduzierten Schutzschicht-Sauerstoff-Partialdruck (S-Partialdruck) sowie einer niedrigen, gegenüber der E-Aufstäubrate reduzierten Schutzschicht-Aufstäubrate (S-Aufstäubrate) aufgebracht wird, so daß einen Verlust an Infrarot-Reflexion und Durchlässigkeit bewirkende Schädigungen der Schutzschicht beim Aufbringen der Entspiegelungsschicht verhindert werden. Nach bevorzugter Ausführungsform der Erfindung wird dabei die metalloxidische Schutzschicht mittels Targets aus einem der Stoffe Zinn, Indium, Indium mit Zinn dotiert, Blei, Zink, Titan, Tantal erzeugt. Wesentlich für die Erfindung ist das Aufbringen der metalloxidischen Schutzschicht. Man kann diese auch mit Hilfe von metalloxidischen Targets aufbringen. Insoweit ist die Lösung der angegebenen Aufgabe dadurch gekennzeichnet, daß auf die Silberschicht vor dem Aufbringen der Entspiegelungsschicht mit Hilfe einer Magnetron-Kathodenzerstäubung und metalloxidischen Targets eine metalloxidische Schutzschicht mit einem niedrigen, gegenüber dem E-Partialdruck reduzierten Schutzschicht-Sauerstoffpartialdruck (S-Partialdruck) sowie einer niedrigen, gegenüber der E-Aufstäubrate reduzierten Schutzschicht-Aufstäubrate (S-Aufstäubrate) aufgebracht wird, so daß einen Verlust an Infrarot-Reflexion und Durchlässigkeit bewirkende Schädigungen der Silberschicht beim Aufbringen der Entspiegelungsschicht verhindert werden. Nach bevorzugter Ausführungsform wird hier die metalloxidische Schutzschicht mittels Targets aus einem der Stoffe Zinnoxid, Indiumoxid, mit Zinnoxid dotiertem Indiumoxid, Bleioxid, Zinkoxid, Titanoxid oder Tantaloxid erzeugt.

Aus ganz anderen Gründen, nämlich nicht um zu verhindern, daß durch das Aufbringen der Entspiegelungsschicht auf die Silberschicht die Infrarot-Reflexionseigenschaften der Silberschicht verschlechtert werden, sondern vielmehr um bei einer Beschichtung des eingangs beschriebenen grundsätzlichen Aufbaus die Alterungsbeständigkeit im späteren Einsatz unter dem Einfluß von Hitze, Licht, atmösphärischen Gasen usw. zu verbessern, ist es bekannt (EP 00 35 906 A2), auf die Silberschicht eine metallische Zwischenschicht, auch aus einem der Metalle Zinn, Indium und anderen, durch Vakuumbeschichtung oder Zerstäubung aufzubringen. Das soll unter Bedingungen erfolgen, die eine Umwandlung dieser Metalle fuhr die Zwischenschicht in ihre Oxide oder andere Verbindungen möglichst verhindern.

Im Rahmen der Erfindung wird für die Entspiegelungsschicht mit Schichtdicken gearbeitet, wie sie bei der Beschichtung von Substraten mit optischen Filtern des beschriebenen Aufbaus üblich sind. Die Dicke der Schutzschicht und der S-Partialdruck sowie der S-Aufstäubrate sind im großen Bereich variabel. Ein Richtwert ist dadurch gekennzeichnet daß die Schutzschicht bei einem S-Partialdruck und bei einer S-Aufstäubrate aufgebracht wird, die um mindestens etwa einen Faktor 0,5 kleiner sind als der E-Partialdruck und die E-Aufstäubrate. Im Detail lehrt die Erfindung, daß auf die Silberschicht einer Schichtdicke zwischen 50 Å und 300 Å die Schutzschicht in einer Dicke zwischen 20 Å und 100 Å und auf diese Schutzschicht die Entspiegelungsschicht aus Zinnoxid in einer Dicke zwischen 250 Å und 600 Å aufgestäubt wird. In diesem Zusammenhang ist eine bevorzugte Ausführungsform der Erfindung dadurch gekennzeichnet, daß die Schutzschicht mit einem S-Partialdruck von kleiner oder gleich 3 x 10⁻⁴ mbar sowie mit einer S-Aufstäubrate von kleiner oder gleich 8 Å/sec, die Entspiegelungsschicht mit einem E-Partialdruck von größer oder gleich 7 x 10⁻⁴ mbar bei einer E-Aufstäubrate von größer oder gleich 20 Å/sec, vorzugsweise 35 Å/sec, aufgebracht werden.

Die Erfindung geht von der Erkenntnis aus, daß beim Aufbringen der Entspiegelungsschicht im Rahmen der bekannten Maßnahmen, insbesondere durch das reaktive Plasma bei der reaktiven Magnetron-Kathodenzerstäubung, atomare Teilchen in die obersten Lagen der Silberschicht hineingeschossen werden, welche die eingangs beschriebenen, störenden Schichtveränderungen bewirken. Arbeitet man nach der Lehre der Erfindung, so gelingt es überraschenderweise, eine Schädigung der Silberschicht vollständig zu verhindern. Die Schutzschicht verhindert eine Schädigung der Silberschicht durch das Aufbringen der Entspiegelungsschicht. Das gilt überraschenderweise selbst dann, wenn sowohl beim Aufbringen der Schutzschicht als auch beim Aufbringen der Entspiegelungsschicht mit reaktiver Magnetron-Kathodenzerstäubung gearbeitet wird. Es hat sich gezeigt, daß für die Schutzwirkung der Schutzschicht bereits Schichtdicken von 20 Å ausreichend sind. Bei Anwendung des erfindungsgemäßen Verfahrens bei einer Durchlaufschleusenanlage wird man zweckmäßigerweise so vorgehen, daß die Kathode für das Aufbringen der Schutzschicht zwischen der Silberkathode und der bzw. den Kathoden für die Entspiegelungsschicht angeordnet ist, wobei die zu beschichtenden Substrate nacheinander diese Sputterstationen passieren. Die Erfindung ist nicht darauf beschränkt, daß im Durchlaufverfahren gearbeitet wird. So können die Schutzschicht und die Entspiegelungsschicht auch nacheinander mit der gleichen Kathode aufgebracht werden, wobei die Beschichtungsparameter nach dem Aufbringen der Schutzschicht auf die Erfordernisse für das Aufbringen der Entspiegelungsschicht umgestellt werden müssen. Bei der Herstellung der Schutzschicht wird man im allgemeinen Targets der entsprechenden Metalle bzw. Metallegierungen für die Zerstäubung einsetzen. Aber auch oxidische Targets können verwendet werden. Bei diesen sind zwar die Aufstäubraten geringer als bei metallischen Targets, aber die für die Schutzschicht erforderlichen Raten von wenigen Ångström pro Sekunde sind mit ihnen ohne weiteres zu erreichen. Die Verwendung oxidischer Targets hat den Vorteil, daß der für die Bildung einer Oxidschicht ohne störende Restabsorption für sichtbares Licht erforderliche Sauerstoffdruck in der Beschichtungskammer niedriger ist als beim Einsatz metallischer Targets. Damit ergibt sich ein größerer Sicherheitsabstand zu dem maximal zulässigen Sauerstoffdruck, um eine Schädigung der Silberschicht zu verhindern.

Im folgenden wird die Erfindung durch Ausführungsbeispiele erläutert.

### Beispiel I:

### (Vergleichsbeispiel)

In eine Vakuum-Beschichtungsanlage, welche mit Kathoden für die Magnetron-Kathodenzerstäubung ausgerüstet war, wurde eine Floatglasscheibe von 4 mm Dicke, Format 200 cm X 100 cm, eingebracht. Die Substratoberfläche wurde bei einem Druck von 4 x 10⁻² mbar einer Glimmreinigung unterzogen. Anschließend wurde der Druck auf den für die Durchführung der Beschichtung erforderlichen Wert erniedrigt. Die Beschichtung erfolgte in der Weise, daß die Floatglasscheibe mit konstanter Geschwindigkeit an den linearen Kathoden mit Abmessungen von 125 cm X 23 cm vorbeibewegt wurde. Für die Beschichtung wurden drei Kathoden eingesetzt, welche mit Targets aus Silber, Zinn und einer Indium-Zinnlegierung der Zusammensetzung 90 % In/10 % Sn bestückt waren.

Nacheinander wurden folgende Schichten aufgebracht:
- eine Zinnoxid-Schicht von 330 Å durch reaktive Zerstäubung von Zinn
- eine mit Zinnoxid dotierte Indiumoxidschicht von 40 Å Dicke durch reaktive Zerstäubung der Legierung 90 % Indium/10 % Zinn
   (diese beiden Schichten bilden zusammen eine zwischen Glasträger und Silberschicht angeordnete erste Entspiegelungsschicht, die auch als Haftschicht funktioniert)
- eine Silberschicht von 80 Å Dicke durch Zerstäubung von Silber in Argon-Atmosphäre.

Auf die Silberschicht wurde anschließend eine Zinnoxidschicht von 400 Å Dicke durch reaktive Zerstäubung des Zinn-Targets aufgebracht. Die Aufstäubrate betrug 35 Å/sec. Die Zerstäubung erfolgte in einer Ar/N₂/O₂-Atmosphäre, wobei der E-Partialdruck 1,4 x 10⁻³ mbar betrug.

Eine anschließende Messung der Infrarotreflexion der beschichteten Scheibe bei Strahlungseinfall von der Luftseite der Beschichtung ergab bei einer Wellenlänge von 8 µm eine Reflexion von 12%. Die Durchlässigkeit der Scheibe bei 5500 Å betrug 51 %.

### Beispiel II:

In gleicher Weise wie in Beispiel I wurden zunächst auf eine Floatglasscheibe eine Zinnoxidschicht von 330 Å, eine mit Zinnoxid dotierte Indiumoxidschicht von 40 Å und eine Silberschicht von 80 Å aufgebracht.
Anschließend wurde durch reaktive Zerstäubung des Zinntargets eine SnO₂-Schicht von 30 Å Dicke aufgebracht. Die Zerstäubung erfolgte mit einer S-Aufstäubrate von 3 Å/sec in einer Ar/N₂/O₂-Atmosphäre bei einem S-Partialdruck von 1 x 10⁻⁴ mbar.

Im Anschluß daran erfolgte die Beschichtung mit einer weiteren Zinnoxidschicht von 360 Å Dicke bei einer E-Aufstäubrate von 35 Å/sec in einer Ar/N₂/O₂-Atmosphäre bei einem E-Partialdruck von 1,4 x 10⁻³ mbar.

Eine Messung der Infrarotreflexion der beschichteten Scheibe von der Luftseite der Beschichtung ergab bei λ = 8 µm eine Reflexion von 92%. Die Transmission bei 5500 Å betrug 84%.

### Beispiel III:

In gleicher Weise wie in Beispiel I wurden zunächst eine Zinnoxidschicht von 330 Å, eine mit Zinnoxid dotierte Indiumoxidschicht von 40 Å und eine Silberschicht von 80 Å Dicke aufgebracht. Anschließend wurde durch reaktive Zerstäubung der Legierung 90 % In/10 % Sn eine mit Zinnoxid dotierte Indiumoxidschicht von 30 Å Dicke aufgebracht. Die S-Aufstäubrate betrug 2 Å/sec und der S-Partialdruck in der Ar/N₂/O₂-Atmosphäre lag bei 8 x 10⁻⁵ mbar.

Im Anschluß daran erfolgte die Beschichtung mit einer Zinnoxidschicht von 360 Å Dicke bei einer E-Aufstäubrate von 35 Å/sec in einer Ar/N₂/O₂-Atmosphäre bei einem E-Partialdruck von 1,5 x 10⁻³ mbar.

Die Infrarot-Reflexion der beschichteten Scheibe bei λ = 8 µm betrug 92 % und die Transmission bei 5500 Å lag bei 84,5 %.

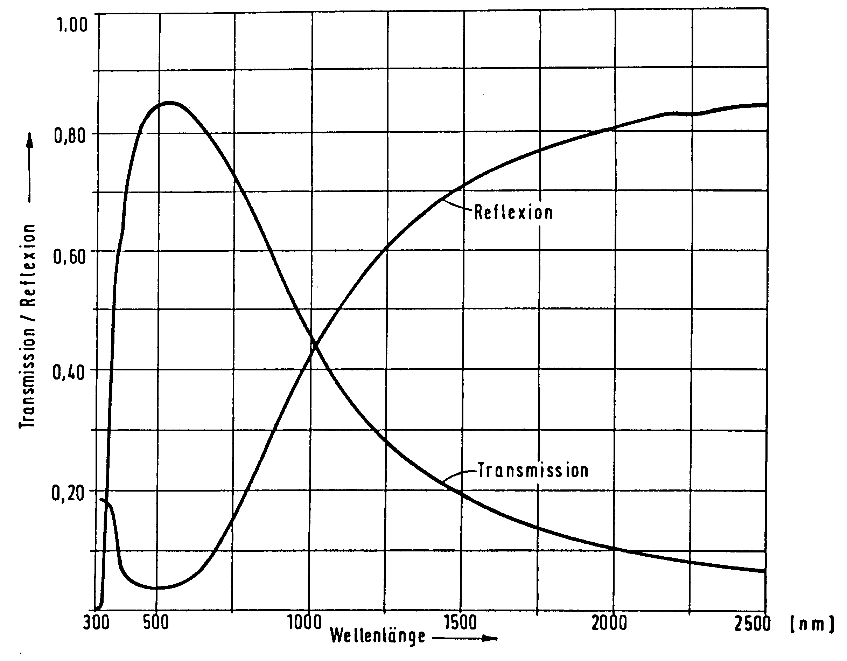

In der einzigen Figur sind die spektralen Transmissionskurven und Reflexionskurven der beschichteten Scheibe, letzte gemessen von der Luftseite der Beschichtung, wiedergegeben. Die Spektralkurven zeigen, daß die beschichtete Scheibe sehr gute Filtereigenschaften aufweist. An den Bereich hoher Transmission im sichtbaren Gebiet mit einer Lichtdurchlässigkeit von 83 %, bezogen auf die Hellempfindlichkeit des menschlichen Auges, schließt sich im nahen Infraroten ein Bereich hoher Reflexion an, wobei im fernen IR Reflexionswerte von 92 % erreicht werden.

## Patentansprüche

1. Verfahren zur Herstellung eines transparenten Substrates mit einem mehrschichtigen optischen Filter, welches mindestens eine Silberschicht und eine nach außen hin nachgeordnete Entspiegelungsschicht aus Zinnoxid aufweist, wobei die Entspiegelungsschicht mit Hilfe einer reaktiven Magnetron-Kathodenzerstäubung bei vorgegebenem Entspiegelungsschicht-Sauerstoffpartialdruck (E-Partialdruck) und vorgegebener Entspiegelungsschicht-Aufstäubrate (E-Aufstäubrate) erzeugt wird, **dadurch gekennzeichnet,** daß auf die Silberschicht vor dem Aufbringen der Entspiegelungsschicht, mit Hilfe einer reaktiven Magnetron-Kathodenzerstäubung und metallischen Targets, eine metalloxidische Schutzschicht mit einem niedrigen, gegenüber dem E-Partialdruck reduzierten Schutzschicht-Sauerstoffpartialdruck (S-Partialdruck) sowie einer niedrigen, gegenüber der E-Aufstäubrate reduzierten Schutzschicht-Aufstäubrate (S-Aufstäubrate) aufgebracht wird, so daß einen Verlust an Infrarot-Reflexion und Durchlässigkeit bewirkende Schädigungen der Silberschicht beim Aufbringen der Entspiegelungsschicht verhindert werden.

2. Verfahren nach Anspruch 1, dadurch gekennzeichnet, daß die metalloxidische Schutzschicht mittels Targets aus einem der Stoffe Zinn, Indium, Indium mit Zinn dotiert, Blei, Zink, Titan, Tantal erzeugt wird.

3. Verfahren zur Herstellung eines transparenten Substrates mit einem mehrschichtigen optischen Filter, welches mindestens eine Silberschicht und eine nach außen hin nachgeordnete Entspiegelungsschicht aus Zinnoxid aufweist, wobei die Entspiegelungsschicht mit Hilfe einer reaktiven Magnetron-Kathodenzerstäubung bei vorgegebenem Entspiegelungsschicht-Sauerstoffpartialdruck (E-Partialdruck) und vorgegebener Entspiegelungsschicht-Aufstäubrate (E-Aufstäubrate) erzeugt wird, **dadurch gekennzeichnet,** daß auf die Silberschicht vor dem Aufbringen der Entspiegelungsschicht, mit Hilfe einer Magnetron-Kathodenzerstäubung und metalloxidischen Targets, eine metalloxidische Schutzschicht mit einem niedrigen, gegenüber dem E-Partialdruck reduzierten Schutzschicht-Sauerstoffpartialdruck (S-Partialdruck) sowie einer niedrigen, gegenüber der E-Aufstäubrate reduzierten Schutzschicht-Aufstäubrate (S-Aufstäubrate) aufgebracht wird, so daß einen Verlust an Infrarot-Reflexion bewirkende Schädigungen der Silberschicht beim Aufbringen der Entspiegelungsschicht verhindert werden.

4. Verfahren nach Anspruch 3, dadurch gekennzeichnet, daß die metalloxidische Schutzschicht mittels Targets aus einem der Stoffe Zinnoxid, Indiumoxid, mit Zinnoxid dotiertem Indiumoxid, Bleioxid, Zinkoxid, Titanoxid oder Tantaloxid erzeugt wird.

5. Verfahren nach einem der Ansprüche 1 bis 4, dadurch gekennzeichnet, daß die Schutzschicht bei einem S-Partialdruck und bei einer S-Aufstäubrate aufgebracht wird, die mindestens um etwa einen Faktor 0,5 kleiner sind als der E-Partialdruck bzw. die E-Aufstäubrate.

6. Verfahren nach einem der Ansprüche 1 bis 5, dadurch gekennzeichnet, daß auf die Silberschicht mit einer Schichtdicke zwischen 50 Å und 300 Å die Schutzschicht in einer Dicke zwischen 20 Å und 100 Å und auf diese Schutzschicht die Entspiegelungsschicht in einer Dicke zwischen 250 Å und 600 Å aufgebracht wird.

7. Verfahren nach Anspruch 6, dadurch gekennzeichnet, daß die Schutzschicht mit einem S-Partialdruck von kleiner oder gleich 3 x 10⁻⁴ mbar sowie einer S-Aufstäubrate von kleiner oder gleich 8 Å/sec, die Entspiegelungsschicht mit einem E-Partialdruck von größer oder gleich 7 x 10⁻⁴ mbar bei einer E-Aufstäubrate von größer oder gleich 20 Å/sec, vorzugsweise 35 Å bis 40 Å/sec, aufgebracht werden.

## Claims

1. A process for producing a transparent substrate having a multi-layer optical filter which comprises at least one silver layer and a reflection-reducing layer of tin oxide disposed outwardly following the latter, wherein the reflection-reducing layer is produced by means of reactive magnetron cathode sputtering at a predetermined reflection-reducing layer oxygen partial pressure (E partial pressure) and at a predetermined reflection-reducing layer sputtering rate (E sputtering rate), characterised in that before the deposition of the reflection-reducing layer a metal oxide protective layer is deposited on the silver layer, by means of reactive magnetron cathode sputtering and a metal target, at a low protective layer oxygen partial pressure (S partial pressure) which is reduced in relation to the E partial pressure, and at a low protective layer sputtering rate (S sputtering rate), which is reduced in relation to the E sputtering rate, so that damage to the silver layer, which causes loss of infrared reflection and transparency, is prevented when depositing the reflection-reducing layer.

2. A process according to claim 1, characterised in that the metal oxide protective layer is produced by means of targets of one of the materials tin, indium, indium doped with tin, lead, zinc, titanium or tantalum.

3. A process for producing a transparent substrate having a multi-layer optical filter which comprises at least one silver layer and a reflection-reducing layer of tin oxide disposed outwardly following the latter, wherein the reflection-reducing layer is produced by means of reactive magnetron cathode sputtering at a predetermined reflection-reducing layer oxygen partial pressure (E partial pressure) and at a predetermined reflection-reducing layer sputtering rate (E sputtering rate), characterised in that before the deposition of the reflection-reducing layer a metal oxide protective layer is deposited on the silver layer, by means of reactive magnetron cathode sputtering and a metal oxide target, at a low protective layer oxygen partial pressure (S partial pressure) which is reduced in relation to the E partial pressure, and at a low protective layer sputtering rate (S sputtering rate), which is reduced in relation to the E sputtering rate, so that damage to the silver layer, which causes loss of infrared reflection, is prevented when depositing the reflection-reducing layer.

4. A process according to claim 3, characterised in that the metal oxide protective layer is produced by means of targets of one of the materials tin oxide, indium oxide, indium oxide doped with tin oxide, lead oxide, zinc oxide, titanium oxide or tantalum oxide.

5. A process according to any one of Claims 1 to 4, characterised in that the protective layer is deposited at an S partial pressure and at an S sputtering rate which are less by at least a factor of about 0.5 than the E partial pressure and the E sputtering rate, respectively.

6. A process according to any one of claims 1 to 5, characterised in that the protective layer is deposited at a thickness between 20 Å and 100 Å on the silver layer, which has a layer thickness between 50 Å and 300 Å, and the reflection-reducing layer is deposited on this protective layer at a thickness between 250 Å and 600 Å.

7. A process according to claim 6, characterised in that the protective layer is deposited at an S partial pressure less than or equal to 3 x 10⁻⁴ mbar and at an S sputtering rate less than or equal to 8 Å/sec, and the reflection-reducing layer is deposited at an E partial pressure greater than or equal to 7 x 10⁻⁴ mbar at an E sputtering rate greater than or equal to 20 Å/sec, preferably 35 Å to 40 Å/sec.

## Revendications

1. Procédé pour fabriquer un substrat transparent comportant un filtre optique multicouche, qui comprend au moins une couche d'argent et une couche antireflet en oxyde d'étain disposée à l'extérieur, la couche antireflet étant produite à l'aide d'une pulvérisation cathodique au magnétron à une pression partielle d'oxygène prédéterminée de la couche antireflet (pression partielle E) et avec un taux de pulvérisation de la couche antireflet (taux de pulvérisation E), caractérisé en ce que, avant l'application de la couche antireflet, on recouvre la couche d'argent, au moyen d'une pulvérisation cathodique réactive au magnétron et de cibles métalliques, avec une couche protectrice d'oxyde métallique en utilisant une faible pression partielle d'oxygène de la couche de protection (pression partielle S), réduite par rapport à la pression partielle E, ainsi qu'un faible taux de pulvérisation de la couche protectrice (taux de pulvérisation S), réduit par rapport au taux de pulvérisation E, de manière à empêcher, lors de l'application de la couche antireflet, des détériorations de la couche d'argent entraînant une réduction de la réflexion du rayonnement infrarouge et de la transparence.

2. Procédé selon la revendication 1, caractérisé en ce que la couche protectrice d'oxyde métallique est produite au moyen de cibles formées par l'un des matériaux suivants : étain, indium, indium dopé à l'étain, plomb, zinc, titane, tantale.

3. Procédé pour fabriquer un substrat transparent comportant un filtre optique multicouche qui comprend au moins une couche d'argent et une couche antireflet en oxyde d'étain disposée à l'extérieur, la couche antireflet étant produite à l'aide d'une pulvérisation cathodique au magnétron à une pression partielle d'oxygène prédéterminée de la couche antireflet (pression partielle E) et avec un taux de pulvérisation de la couche antireflet (taux de pulvérisation E), caractérisé en ce que, avant l'application de la couche antireflet, on recouvre la couche d'argent, au moyen d'une pulvérisation cathodique réactive au magnétron et de cibles métalliques, avec une couche protectrice d'oxyde métallique en utilisant une faible pression partielle d'oxygène de la couche protectrice (pression partielle S), réduite par rapport à la pression partielle E, ainsi qu'un faible taux de pulvérisation de la couche de protection (taux de pulvérisation S), réduit par rapport au taux de pulvérisation E, de manière à empêcher, lors de l'application de la couche antireflet, des détériorations de la couche d'argent entraînant une réduction de la réflexion du rayonnement infrarouge.

4. Procédé selon la revendication 3, caractérisé en ce que la couche protectrice d'oxyde métallique est réalisée à l'aide de cibles formées de l'un des matériaux suivants : oxyde d'étain, oxyde d'indium, oxyde d'étain dopé avec de l'oxyde d'indium, oxyde de plomb, oxyde de Zinc, oxyde de titane ou oxyde de tantale.

5. Procédé selon l'une des revendications 1 à 4, caractérisé en ce que la couche protectrice est déposée avec une pression partielle S et un taux de pulvérisation S, qui sont inférieurs, approximativement d'un facteur 0,5, à la pression partielle E et au taux de pulvérisation E.

6. Procédé selon l'une des revendications 1 à 5, caractérisé en ce qu'on dépose la couche protectrice possédant une épaisseur comprise entre 20 Å et 100 Å sur la couche d'argent possédant une épaisseur comprise entre 50 Å et 300 Å, et qu'on dépose sur cette couche protectrice une couche antireflet possédant une épaisseur comprise entre 250 Å et 600 Å.

7. Procédé selon la revendication 6, caractérisé en ce qu'on dépose la couche protectrice avec une pression partielle S inférieure ou égale à 3 x 10⁻⁴ mbars ainsi qu'avec un taux de pulvérisation S inférieur ou égal à 8 Å/s, et qu'on dépose la couche antireflet avec une pression partielle E supérieure ou égale à 7 x 10⁻⁴ mbars pour un taux de pulvérisation E supérieur ou égal à 20 Å/s, de préférence compris entre 35 A et 40 Å/s.
